# EUROPÄISCHE PATENTSCHRIFT

(11) **EP 0 686 210 B1**
(45) Veröffentlichungstag und Bekanntmachung des Hinweises auf die Patenterteilung: **16.05.2001**
(21) Anmeldenummer: 94908261.4
(22) Anmeldetag: 18.02.1994
(51) Int. Cl.: C23C 14/10, B65D 65/42

(54) **IM VAKUUM AUFGEDAMPTE BARRIERESCHICHTEN FÜR DIE VERPACKUNGSINDUSTRIE UND AUFDAMPFGUT FÜR IHRE HERSTELLUNG**
VACUUM-VAPOUR-PHASE DEPOSITED BARRIER LAYER FOR THE PACKAGING INDUSTRY AND VAPORIZED SUBSTANCE FOR PRODUCING THE SAME
COUCHES FORMANT BARRIERE DEPOSEES PAR VAPORISATION SOUS VIDE UTILES DANS L'INDUSTRIE DE L'EMBALLAGE ET MATIERE A VAPORISER SOUS VIDE

(30) Priorität: 25.02.1993 DE 4305856
(43) Veröffentlichungstag der Anmeldung: 13.12.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: DE RUDNAY, André, Château de Valency, CH-1004 Lausanne (CH)
(86) Internationale Anmeldenummer: DE9400197
(87) Internationale Veröffentlichungsnummer: WO9419506

(56) Entgegenhaltungen:
- EP-A- 0 460 796
- EP-A- 0 492 583
- EP-A- 0 549 528
- DE-B- 1 696 110
- PATENT ABSTRACTS OF JAPAN vol. 9, no. 153 (C-288)(1876) 27. Juni 1985 & JP,A,60 029 465 (SEKISUI CHEMI IND KK) 14. Februar 1985
- PATENT ABSTRACTS OF JAPAN vol. 012, no. 444 (C-545)22. November 1988 & JP,A,63 166 965 (KOUJIYUNDO KAGAKU KENKYUSHO:KK) 11. Juli 1988
- PATENT ABSTRACTS OF JAPAN vol. 013, no. 457 (C-644)16. Oktober 1989 & JP,A,01 176 069 (TOYO INK MFG CO LTD) 12. Juli 1989

## Beschreibung

Die Erfindung betrifft ein Verfahren zur Herstellung von im Vakuum auf Verpackungsfolien aufgedampften SiOₓ-Barriereschichten, die zur Eindämmung einer Schrumpfung und der damit verbundenen Rißbildung außer Silicium und Sauerstoff auch eine Verbindung von Bor enthalten. Die Erfindung betrifft gleichfalls ein neues in fester Form verwendbares Aufdampfgut zur Herstellung von Silicium, Bor und Sauerstoff enthaltenden Barriereschichten.

Es ist bekannt, daß im Vakuum auf verschiedene Folien von einem aus SiO bestehenden Festkörper abgedampfte (sublimierte) Dünnschichten hervorragende Barriereeigenschaften besitzen. Doch werden diese in der Lebensmittelverpackung nur ausnahmsweise eingesetzt, denn der Aufwand ist sehr hoch: die Herstellung vom Aufdampfgut ist umständlich und sein Einsatz nur unter bestimmten, zum Teil schwer kontrollierbaren Bedingungen möglich. Der durch Gettern angereicherte Sauerstoffanteil der kondensierten Schicht (im Verhältnis zum Siliciumanteil) soll nicht weniger als 1.8 betragen, sonst tritt eine unerwünscht hohe Absorption des kurzwelligen Teiles des sichtbaren Spektrums ein. Erreicht aber der Sauerstoffanteil 2, entspricht also die chemische Zusammensetzung der kondensierten Schicht der Formel SiO₂, so unterscheidet sich die Gasdurchlässigkeit der beschichteten Folie nicht oder kaum mehr von derjenigen einer unbeschichteten Folie. Dieser Umstand ist um so überraschender, als mit Ausnahme von Helium und Wasserstoff die Gase und Dämpfe nur äußerst langsam durch Quarzglas diffundieren, während ihre Diffusionsgeschwindigkeit durch Kristallquarz noch um weitere Zehnerpotenzen niedriger liegt.

Es ist weiterhin bekannt (R.M. Barrer, 1934, J. Chem. Soc. Lond., 378), daß Helium und Wasserstoff durch das Netzwerk von SiO₂ diffundieren, die viel größeren Atome und Moleküle von Sauerstoff usw. hingegen lediglich über Risse im SiO₂-Festkörper diffundieren können.

Auch ist es bekannt, daß SiO₂ in mehreren Modifikationen vorkommt. Ihre Dichte reicht von 2.2 g/cm³ (Quarzglas sowie alpha-Cristobalit) bis 2.65 g/cm³ (beta-Quarz), wobei die weniger stabilen niedrigeren Modifikationen teilweise bereits bei verhältnismäßig niedrigen Temperaturen (so alpha-Cristobalit bei 180 bis 270 °C) in stabilere höhere, d.h. dichtere Modifikationen umgewandelt werden. Dünne Schichten können sich bereits bei Zimmertemperatur in eine stabilere Modifikation umwandeln. Die Umwandlung wird sinngemäß von einem Schrumpfen begleitet.

Weiterhin ist es bekannt, daß, falls eine Kunststoff-Folie wie beispielsweise eine PET-Folie nicht nur einseitig, sondern beidseitig mit je einer identischen SiOₓ-Barriereschicht bedampft wird, die Sauerstoffpermeabilität nicht um 50 %, sondern überraschenderweise um mehr als eine Zehnerpotenz abnimmt.

Aus der EP 492 583 A2 ist ein Verfahren zur Erzeugung eines Überzuges bekannt bei dem vorgesehen ist, Pyrexglas und SiO₂ zu schmelzen und dann die so gebildete Schmelze aufzudampfen. Bei diesem Verfahren wird demgemäß zuerst aus Glas und SiO₂ eine Schmelze gebildet und dann weiter verarbeitet.

Aufgabe der Erfindung ist es daher, ein Verfahren und ein Aufdampfgut anzugeben, das eine Umwandlung der Barriereschicht in eine stabilere Modifikation, die stets von Schrumpfen und Rißbildung und somit mit einem Anstieg der Gaspermeabilität verbunden ist, zu verhüten oder wenigstens auf ein Mindestmaß zu beschränken.

Die Erfindung wird durch die kennzeichnenden Merkmale des Patentanspruches 1 gelöst. Die Unteransprüche zeigen vorteilhafte Weiterbildungen auf.

Erfindungsgemäß wird somit vorgeschlagen, drei getrennt vorliegende chemische Substanzen bestehend aus Silicium, einer Sauerstoffverbindung von Silicium sowie aus Bor oder einer Borverbindung zu einem Festkörper zu verfestigen und dann aufzusublimieren.

Der kondensierte Dampf enthält dabei außer Silicium und Sauerstoff mindestens eine weitere Komponente, die eine Umwandlung und die dadurch eintretende Rißbildung der kondensierten Schicht verhindert. Die Rißbildung beschränkt sich dementsprechend vorzugsweise nur auf eine solche, die bei dem Aufkondensieren einer keramischen Schicht auf eine organische Folie und bei ihrer nachfolgenden Handhabung unvermeidlich ist. Dazu eignen sich Zusätze, die in erster Linie Bor, insbesondere Sauerstoffverbindungen von Bor, enthalten, die in einem hauptsächlich aus

Silicium und Sauerstoff bestehenden Kondensat die kondensierte Modifikation bereits bei Zugabe von kleinen Mengen stabilisieren und somit ihr umwandlungsbedingtes Schrumpfen verhüten. Dieses Vorhaben kann sowohl nach bekannten als auch nach neuen Verfahren realisiert werden.

Obwohl Bor als Stabilisierungsmittel bevorzugt ist, sieht die Erfindung auch die Möglichkeit vor, zusammen mit Bor auch andere Glasbildner als Stabilisierungsmittel einzusetzen. Auch kann die kondensierte Barriereschicht solche zusätzlichen Elemente oder Verbindungen enthalten, die nicht zur Gruppe der Glasbildner gehören.

Die Erfindung sieht die Benützung dieser oder anderer bekannter Verfahren zur Herstellung der neuen Barriereschichten vor. Sie verwendet aber vorzugsweise ein weniger aufwendiges Aufdampfgut, welches keine getrennten Aufdampfquellen oder teueren Ausgangsprodukte wie SiO oder B benötigt. Es wird dementsprechend von einer einzigen, vorzugsweise kontinuierlich gefütterten Aufdampfquelle eine verfestigte Mischung bestehend aus elementarem Si, einer seiner kostengünstigen Sauerstoffverbindungen, wie beispielsweise SiO₂, sowie einer Borverbindung, z.B. B₂O₃, durch Erwärmung, z.B. durch Bestrahlung mit Photonen oder Elektronen, Schicht um Schicht abgedampft (absublimiert), wodurch eine gleichbleibende Zusammensetzung des erzeugten Dampfstrahles begünstigt und ein Kondensat stets gleicher Zusammensetzung erzielt werden kann.

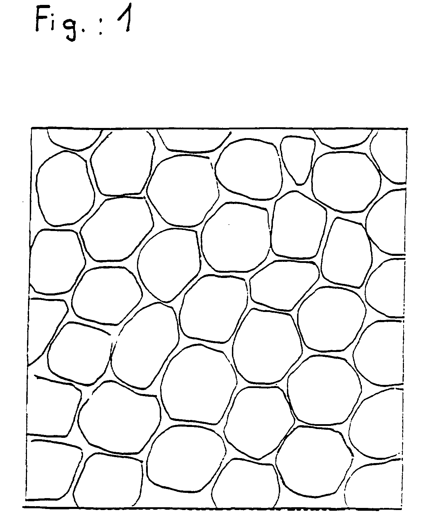

Die Erfindung wird nachfolgend anhand der Figuren 1 bis 3 näher erläutert.
- Fig. 1: ist eine stark vergrößerte schematische Darstellung einer auf eine Seite einer Folie aus einer stoechiometrischen Mischung von SiO₂ und Si aufgedampften Barriereschicht, die in eine stabilere Modifikation umgewandelt wurde, dementsprechend schrumpfte und durch verhältnismäßig breite unbeschichtete, d.h. gaspermeable Kanäle getrennte Inseln bildete.

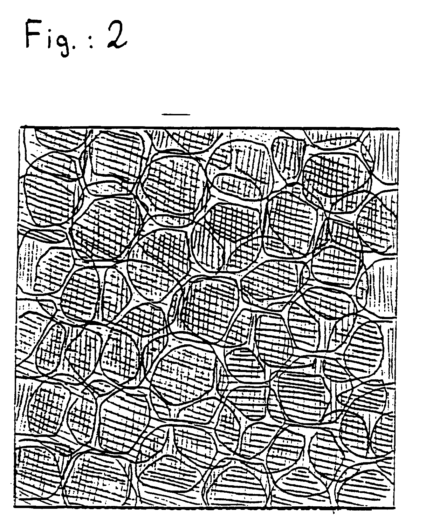

- Fig. 2: ist eine stark vergrößerte schematische Darstellung einer beidseitig nach dem gleichen Verfahren beschichteten Folie, die zeigt, daß die für die Gaspermeabilität verantwortliche unbeschichtete Folienoberfläche auf die Kreuzpunkte der Trennkanäle der auf beiden Seiten der Folie gebildeten Inseln beschränkt und somit im Vergleich zur Gaspermeabilität der auf Fig. 1 gezeigten Folie beträchtlich vermindert wird.

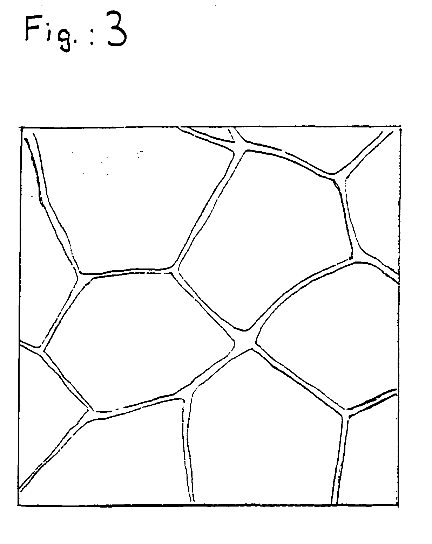

- Fig. 3: ist eine ebenfalls stark vergrößerte schematische Darstellung einer auf eine Seite einer Folie gemäß der Erfindung aufgedampften Barriereschicht, die eine im Vergleich mit der auf Fig. 1 schematisch abgebildeten Barriereschicht eine kleinere Anzahl von Rissen, die auch weniger breit sind, aufweist und somit eine trotz der nur einseitigen Beschichtung sehr geringe Gaspermeabilität aufweist.

Fig. 1 zeigt schematisch und stark vergrößert das Schrumpfen und die Rißbildung einer auf eine 12 Mikrometer starken PET-Folie in einem Vakuum von etwa 10⁻⁴ mbar aufgedampften, etwa 80 nm starken SiOₓ-Schicht. Als Aufdampfgut wurde eine stoechiometrische Mischung von SiO₂ und Si verwendet. Der bei 23°C an mehreren Stellen der beschichteten Folie gemessene Durchschnittswert der Sauerstoffpermeabilität betrug 9 ml/m².Tag.bar, gemessen bei einer Luftfeuchtigkeit von 75%.

Fig. 2 zeigt schematisch und stark vergrößert die Kreuzpunkte, die die durch Schrumpfen der aufgedampften Schicht freigelegten Kanäle auf einer beidseitig unter den gleichen Bedingungen bedampften Folie bilden. Man sieht, daß die von einer Barriereschicht nicht geschützten Teile der Folie auf ein Bruchteil des in Fig. 1 geschilderten Zustandes gesunken sind. Die wiederum bei 23°C gemessene durchschnittliche Sauerstoffpermeabilität betrug weniger als 0.5 ml/m².Tag.bar.

Fig. 3 zeigt schematisch und stark vergrößert das in Vergleich zu Fig. 1 erheblich verminderte Schrumpfen einer auf eine gleiche PET-Folie aufkondensierten Barriereschicht, die ebenfalls aus einer stoechiometrischen Mischung von SiO₂ und Si, der aber (auf die Mischung berechnet) 5 Gewichtsprozent B₂O₃ zugegeben wurde, bedampft wurde. Die Sauerstoffpermeabilität der unter denselben Bedingungen gemessenen, mit einer rund 800 nm starken Barriereschicht versehenen Folie betrug durchschnittlich 1.4 ml/m².Tag.bar.

Weitere Versuche ergaben, daß bereits kleinste Zugaben, beispielsweise nur 1 Mol% Bor, bezogen auf Si, eine Verbesserung der Barriere ergeben, und daß auch bedeutend höhere Anteile von B₂O₃, beispielsweise 25 Gewichtsprozent einer aus SiO₂ und Si bestehenden stoechiometrischen Mischung, nicht die sonst für Boroxid charakteristische Feuchtigkeitsempfindlichkeit verursachten.

Ein weiterer Vorteil des Borgehaltes im Aufdampfgut besteht in seiner Wirkung als Bleichmittel, indem selbst anfänglich bräunlich verfärbte Barriereschichten nach wenigen Tagen soviel Sauerstoff aufnehmen, daß die ursprünglich bräunliche Färbung verschwindet und die beschichteten Klarfolien bereits im kurzwelligen Bereich des sichtbaren Spektrums eine Lichtdurchlässigkeit von rund 90% aufweisen. Dieses nachträgliche Oxydieren führt auch zu einer vorteilhaften Erhöhung der Packungsdichte der auf der Kunststoff-Folie kondensierten, die Barriere erzeugenden Moleküle.

Nicht zuletzt wirkt sich die Zugabe von Bor und mancher seiner Verbindungen, insbesondere seiner Sauerstoffverbindungen, vorteilhaft auf das Verdampfen von Siliciumverbindungen aus. So kann Bor oder ein Boroxid oder eine andere Borverbindung nicht nur einer Mischung von etwa einem Gewichtsteil Si und zwei Gewichtsteilen SiO₂ beigegeben werden, der Anteil von SiO₂ kann vielmehr um 50% oder mehr erhöht oder gesenkt werden, ohne den Auf dampfprozeß oder die Barriereeigenschaften aufzuheben.

In den angeführten Beispielen wurde stets von etwa 80 nm starken Barriereschichten berichtet, doch können erfindungsgemäß beliebige Stärken zwischen 10 und 500 nm mit Sauerstoffpermeabilitäten bis unter 1 ml/m².Tag.bar eingesetzt werden. Ebenfalls können außer PET die verschiedensten Verpackungsfolien in den verschiedensten Vakuum-Bandbeschichtungsanlagen mit einer Silicium, Bor und Sauerstoff enthaltenden Barriereschicht belegt werden. So können zur Beschichtung erfindungsgemäß auch Aufstäubeanlagen, Anlagen mit Bogenentladung oder einer anderen Form der Plasmatechnik, Anlagen zum unmittelbaren Erwärmen des Aufdampfgutes mittels Induktionswärme usw. verwendet werden.

## Patentansprüche

1. Verfahren zur Herstellung von im Vakuum auf Folien aufgebrachter anorganischer Barriereschichten (Permeationssperrschichten) für die Verpakkungsindustrie,
dadurch **gekennzeichnet**,
daß drei getrennt vorliegende chemische Substanzen, bestehend aus Si, einer Sauerstoffverbindung von Si sowie aus B oder einer Borverbindung zu einem Festkörper verfestigt, die Komponenten des verfestigten Festkörpers durch Erhitzen zur Reaktion gebracht und die im Laufe der Reaktion vom Festkörper absublimierten Dämpfe auf den Folien aufkondensiert werden.

2. Verfahren nach Anspruch 1,
dadurch gekennzeichnet, daß dem Aufdampfgut vor oder nach dem Verfestigen eine weitere chemische Substanz getrennt oder als Bestandteil einer der drei Hauptkomponenten zugeführt wird.

3. Verfahren nach Anspruch 1 und 2,
dadurch gekennzeichnet, daß der Festkörper einem energiereiche Teilchen erzeugenden Strahler kontinuierlich oder intermittierend zugeführt wird.

4. Verfahren nach mindestens einem der Ansprüche 1 bis 3,
dadurch gekennzeichnet, daß mit einer Bandbedampfungsanordnung gearbeitet wird.

5. Aufdampfgut zur Herstellung von anorganischen Barriereschichten (Permeationssperrschichten) auf Verpackungsfolien,
nach den Ansprüchen 1 bis 4,
dadurch **gekennzeichnet**,
daß das Aufdampfgut mindestens Si und B oder eine Borverbindung enthält und aus einem verfestigten und beim Erhitzen aufsublimierenden Festkörper besteht.

## Claims

1. Method of manufacturing inorganic barrier layers (permeating barrier layers) applied in a vacuum to films for the packaging industry,
**characterised in that**
three chemical substances, present separately and comprising Si, an oxygen compound of Si, and B or a boron compound, are solidified to form a solid, the components of the solidified solid are then brought by heating to a reaction, and the vapours extracted from the solid by sublimation in the course of the reaction are condensed on the films.

2. Method according to claim 1,
**characterised in that** to the vaporised substance is added, before or after solidification, a further chemical substance either separately or as a constituent of one of the three main components.

3. Method according to claim 1 and 2,
**characterised in that** the solid matter is supplied continuously or intermittently to a radiation source generating high-energy particles.

4. Method according to at least one of claims 1 to 3,
**characterised in that** the process is carried out with a strip-coating arrangement.

5. Vaporised substance to produce inorganic barrier layers (permeation barrier layers) on packaging films, according to claims 1 to 4,
**characterised in that** the vaporised substance contains at least Si and B or a boron compound and consists of a solidified solid which is deposited by sublimation when heated.

## Revendications

1. Procédé de fabrication de couches formant barrière inorganique déposé sous vide sur des feuilles (couches barrières à la perméation) pour l'industrie de l'emballage,
caractérisé en ce qu'
on solidifie sur les feuilles trois substances chimiques présentes séparément, constituées de Si, d'un composé oxygéné de Si, ainsi que de B ou d'un composé de bore en un corps solide, en ce qu'on fait réagir par chauffage les composants du solide solidifié, et en ce qu'on condense sur les feuilles les vapeurs sublimées au cours de la réaction du solide.

2. Procédé selon la revendication 1,
caractérisé en ce qu'
on ajoute à la matière à vaporiser, avant ou après la solidification, une autre substance chimique séparée ou en tant que constituant d'un des trois composants principaux.

3. Procédé selon la revendication 1 ou 2,
caractérisé en ce que
le corps solide est ajouté à un appareil d'irradiation produisant des particules riches en énergie de façon continue ou intermittente.

4. Procédé selon au moins une des revendications 1 à 3,
caractérisé en ce qu'
on travaille avec un dispositif de vaporisation en bandes.

5. Matière à vaporiser pour la production de couches formant barrière inorganique (couches barrière à la perméation) sur des feuilles d'emballage selon les revendications 1 à 4,
caractérisée en ce que
la matière à vaporiser contient au moins Si et B ou un composé de bore et se compose d'un solide solidifié et se sublimant au chauffage.
